# EUROPEAN PATENT SPECIFICATION

(11) **EP 0 852 898 B1**
(45) Date of publication and mention of the grant of the patent: **25.08.1999**
(21) Application number: 97927300.0
(22) Date of filing: 25.06.1997
(51) Int. Cl.: H05K 7/20, F28F 1/12, F28F 1/42

(54) **ENCLOSURE FOR ELECTRONIC EQUIPMENT**
GEHÄUSE FÜR ELEKTRONISCHE BAUGRUPPE
CAISSON POUR INSTALLATION ELECTRONIQUE

(30) Priority: 25.06.1996 GB 9613265
(43) Date of publication of application: 15.07.1998
(73) Proprietor: Reddicliffe, Edward A., Lymington, Hants SO41 8PS (GB)
(72) Inventor: Reddicliffe, Edward A., Lymington, Hants SO41 8PS (GB)
(74) Representative: Jackson, Peter Arthur
(86) International application number: GB9701691
(87) International publication number: WO9750282

(56) References cited:
- DE-A- 2 704 161
- DE-A- 2 717 147
- FR-A- 1 494 133
- FR-A- 2 059 945
- FR-A- 2 576 679
- GB-A- 2 284 659

## Description

The present invention relates to an electronic enclosure, and in particular to the way in which such an enclosure is cooled.

The enclosures are used to house electronic components, for example, in street side environments or large buildings such as factories. Modern enclosures contain an increasing volume of active electronic equipment which produces an increasing amount of heat. This heat has to be dissipated in order to avoid damaging the electronic equipment, which can be a particular problem on hot sunny days where a combination of a high ambient temperature and sunlight radiant on the casing of the enclosure causes further temperature increases.

Conventionally, a fan has been used to blow air through the enclosure so as to cool the electronic components. However, this introduces contaminants, such as diesel, from the ambient air causing the build up of a film which acts as an insulator on the electronic components thereby causing them to be further heated. To avoid this, filters can be used. However these must be very fine and so act as a barrier to air flow. They also require periodic replacement or cleaning. Alternatively, the electronic components can be sealed in a thermal chamber, so that some form of heat exchanger is required to cool the chamber. Water cooled heat exchangers require expensive seals in order to ensure that water is prevented from leaking onto electronic components. Refrigeration units are relatively expensive and the switching of pumps in the refrigerant units produces electronic spikes and pulses which causes an electromagnetic compatibility (EMC) problem.

Air to air heat exchangers have been found to be advantageous in that the presence of a continuously running fan meets the necessary EMC standard by avoiding electronic pulses and spikes. However, the thermal transfer in existing air to air heat exchangers is poor.

One existing system using an air to air heat exchanger has a system of fins on both sides of the wall of the thermal chamber and a fan on each side of the wall to blow air across the fins. The fins on the inside of the chamber absorb heat from within the chamber which is then conducted to the fins externally of the chamber, where it is radiated into the stream of cool air produced by the external fan. As this is an inefficient arrangement it will only function adequately when there is a relatively large differential between the temperatures inside and outside the thermal chamber. Therefore, the system does not function adequately on hot days when it is needed most. To provide adequate cooling a number of these cooling assemblys are necessary. However, each assembly requires its own pair of fans, one of which must be mounted within the thermal chamber, so that the use of several systems is expensive, and uses up precious space within the thermal chamber.

DE-A-2717147 discloses a heat exchanger having a tube with internal ribs and external fins.

FR-A-2576679 discloses an electronic enclosure comprises a casing, a sealed thermal chamber within the casing housing electronic components, a heat exchanger mounted in the casing externally of the chamber, a first duct leading from the thermal chamber to the heat exchanger and a second duct leading from the heat exchanger back to the thermal chamber, and a fan for forcing air from the chamber through the first duct to the heat exchanger and back to the thermal chamber through the second duct.

According to the present invention, such an enclosure is characterised in that the heat exchanger is an element comprising a thermally conductive tubular member having a plurality of thermally conductive fins extending radially outwardly from its external surface, and a plurality of thermally conductive rods which extend radially inwardly from the internal surface of the tubular member and are circumferentially and axially staggered; wherein the first and second ducts are connected to the tubular member so that the air from the thermal chamber is blown from the first duct through the tubular member and into the second duct to be returned to the thermal chamber.

Such an arrangement has the EMC advantages of an air to air heat exchanger and is more efficient than the air to air heat exchanger described above.

The capacity of the system can be increased by varying the size of the heat exchanger without necessarily providing additional fans. This can be done if the heat exchanger comprises a number of heat exchange elements connected in parallel. The number of elements can be chosen to suit each particular purpose.

Preferably the fan is an axial fan, and the heat exchange elements are circumferentially spaced about and radially spaced from the axis of the fan.

The fan may be mounted externally of the thermal chamber so that none of the components are within the chamber.

Although the heat exchangers can simply be left to radiate heat to the surrounding air, it is more efficient to provide a further fan to blow air over the external surface of the heat exchanger.

If further cooling of the air removed from the thermal chamber is required, an additional chilling unit can be provided to extract heat from the second duct.

The present invention also gives the option of heating the air externally of the heat exchangers simply by providing a heater, so that the air from the thermal chamber can be heated, in order to prevent the excessive cooling of the thermal chamber when the enclosure is being used in a cold environment.

In order to control the temperature within the thermal chamber, a thermal sensor is preferably provided within the thermal chamber and the speed of the fan is varied to maintain the temperature within the thermal chamber at a desired level. In order to avoid any inaccuracies in the sensed temperature caused by hot spots within the thermal chamber, a plurality of sensors, for example four, are provided and any abnormally high readings from one sensor may be disregarded, or used as a warning to increase fan speed for safety while investigations are made into the cause of the abnormal reading.

The presence of the rods within the tubular member of the heat exchanger has two effects. Firstly, the rods cause turbulence of the air within the tubular member to provide improved heat transfer through the wall of the tubular member, without impeding the flow of air through the tubular member to provide an appreciable pressure drop. Secondly, the rods themselves are heated by the hot air and conduct the heat to the wall of the tubular member.

Preferably, the rods are arranged in an helix extending along the axis of the tubular member.

Additional chilling devices may be incorporated into the element to improve heat exchange.

The ratio of the internal diameter of the tubular member to its length is preferably within the range 0.05 to 0.2, and is more preferably within the range 0.14 to 0.16.

An example of an electronic enclosure with a heat exchange element constructed in accordance with the present invention will now be described with reference to Figures 1 to 4, in which:
Fig. 1 is a plan view showing the arrangement for cooling the thermal enclosure;
Fig. 2 is a section taken along line II-II in Fig. 1;
Fig. 3 is a diagrammatic broken axial view of the heat exchange element with the front of the tubular member removed;
Fig. 4 is a plan view of the heat exchange element;
Fig. 5 is a diagrammatic side view of an advantageous arrangement of heat exchange elements; and
Fig. 6 is an enlarged cross section through lines VI - VI on Fig. 5.

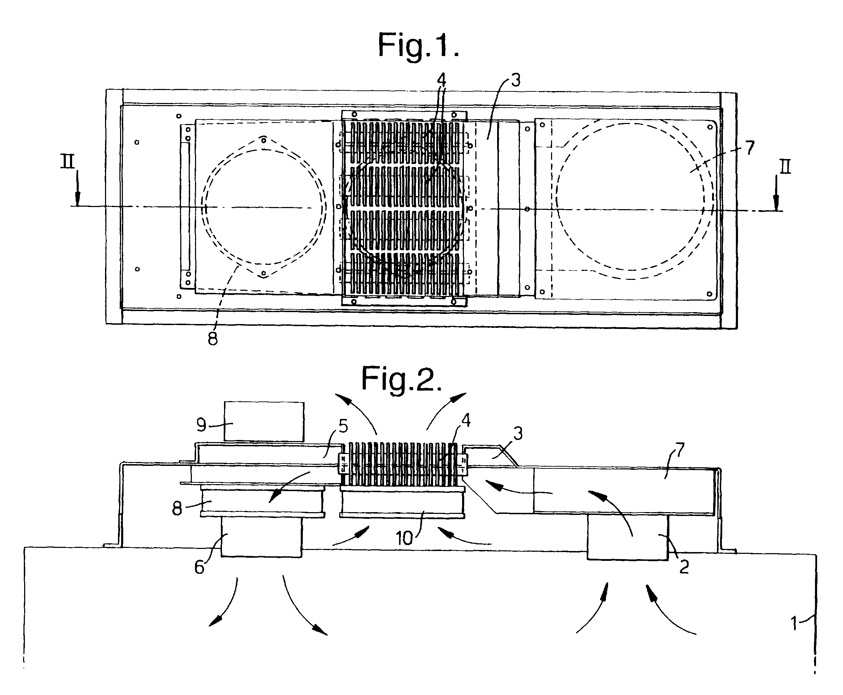

Fig. 2 shows a sealed thermal chamber 1 which houses a variety of active electronic components (not shown). A first duct 2 is sealably connected to the thermal chamber 1 and leads to a first manifold 3 which is connected to a plurality of parallel heat exchanger elements 4. The heat exchange elements discharge air into a second manifold 5 and second duct 6 which is sealably connected to the thermal chamber to complete a closed loop. Air is driven around this closed loop by means of a first fan 7 upstream of the heat exchange elements 4 and a second fan 8 downstream of the heat exchange elements 4. The fans typically operate at 50% of capacity during daytime in winter and 80% of capacity during daytime in summer. To provide further cooling, an additional chilling device 9 is optionally provided to remove heat from the second manifold 5.

A third fan 10 blows heat across the outside of the heat exchangers 4. The above described elements, ducts, manifolds and fans fit conveniently on top of the thermal chamber beneath a lid of a double skinned casing. The air for the third fan 10 is drawn from outside of the casing (not shown) through gaps between the two skins of the casing, and the heated air is expelled to the outside through gaps between the lid and main body of the casing.

The speed of the fans is controlled in accordance with readings from four temperature sensors (not shown) at various locations within the thermal chamber 1.

In order to increase further the capacity of the system, the arrangement shown to the right of the axis of the second duct in Figs. 1 and 2 can be duplicated on the left, for example, in mirror image form. In this case, the additional manifold leading from the further set of heat exchange elements discharges into the second duct 6.

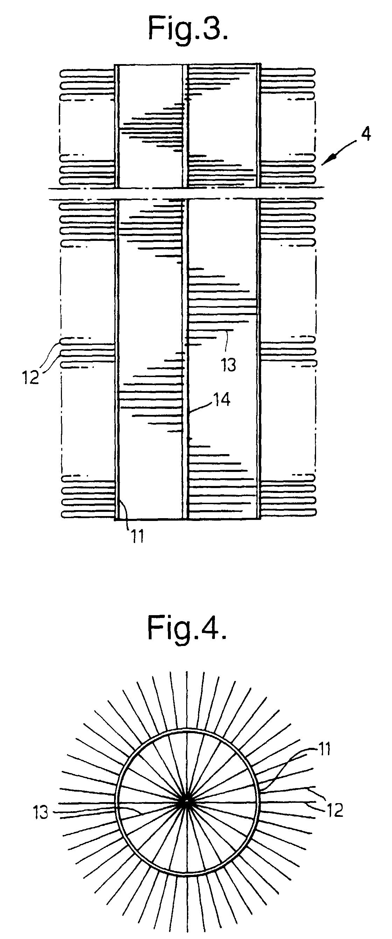

The detailed construction of one heat exchanger element 4 is shown in Figures 3 and 4. The element has a metal tubular body 11 from which a plurality of vanes, in the form of wire loops 12, project. These vanes increase the surface area which is available to transfer heat to the stream of air from the third fan 10. Within the tubular member 11 are provided a plurality of rods 13 which extend radially from a further rod 14 extending along the axis of the tubular body 12. The rods are arranged in a helix extending along the axis of the heat exchanger. As hot air is blown through the tubular member, the rods 13 create turbulence in the flow of air, and also conduct heat to the tubular member.

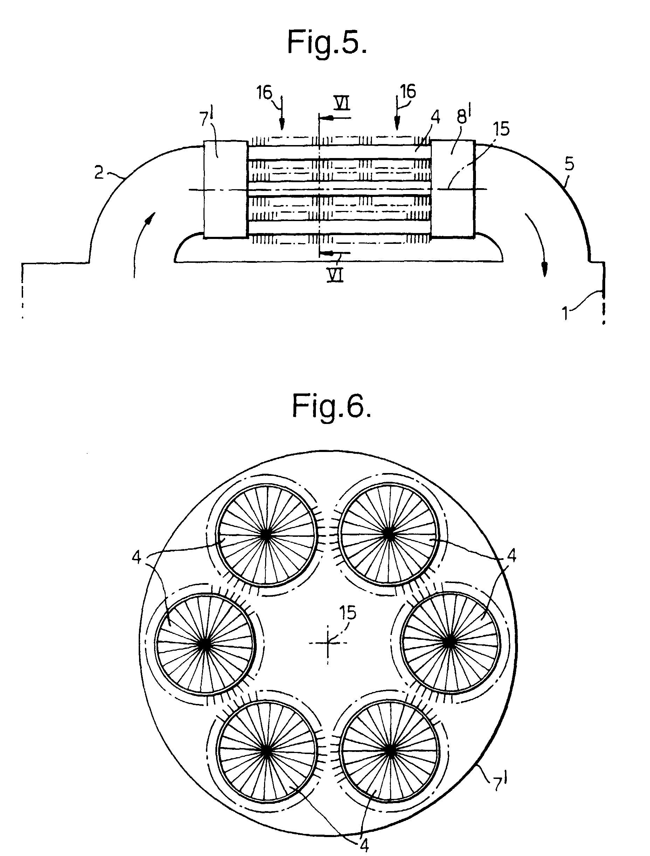

Figs. 5 and 6 show a further example of the present invention. In this example, the fans 7' 8' are axial fans having an axis 15. The heat exchange elements 4 are arranged circumferentially equally spaced around and axially spaced from the axis 15. In use, the axial fans 7' 8' generate an annular flow of air in an envelope containing the heat exchange elements 4. This arrangement has been found to be particularly efficient, but still allows good cross flow of the cooling air as shown by arrows 16 in Fig. 5.

## Claims

1. An electronic enclosure comprises a casing, a sealed thermal chamber (1) within the casing housing electronic components, a heat exchanger (4) mounted in the casing externally of the chamber, a first duct (2) leading from the thermal chamber to the heat exchanger and a second duct (6) leading from the heat exchanger back to the thermal chamber, and a fan (7,8) for forcing air from the chamber through the first duct to the heat exchanger and back to the thermal chamber through the second duct, characterised in that the heat exchanger is an element (4) comprising a thermally conductive tubular member (11) having a plurality of thermally conductive fins (12) extending radially outwardly from its external surface, and a plurality of thermally conductive rods (13) which extend radially inwardly from the internal surface of the tubular member and are circumferentially and axially staggered; wherein the first (2) and second (6) ducts are connected to the tubular member (11) so that the air from the thermal chamber (1) is blown from the first duct through the tubular member and into the second duct to be returned to the thermal chamber.

2. An enclosure according to claim 1, wherein the heat exchanger comprises a number of heat exchange elements (4) connected in parallel.

3. An enclosure according to claim 2, wherein the fan is an axial fan (7,8), and the heat exchange elements (4) are circumferentially spaced about and radially spaced from the axis (15) of the fan.

4. An enclosure according to any one of the preceding claims, wherein the fan (7,8) is mounted externally of the thermal chamber (1) so that none of the components is within the chamber.

5. An enclosure according to any one of the preceding claims, wherein a further fan (10) is provided to blow air over the external surface of the heat exchanger (4).

6. An enclosure according to any one of the preceding claims, wherein an additional chilling unit (9) is provided to extract heat from the second duct (6).

7. An enclosure according to any one of the preceding claims, wherein a thermal sensor is provided with the thermal chamber (1) and the speed of the fan is varied to maintain the temperature within the thermal chamber at a desired level.

8. An enclosure according to claim 7, wherein a plurality of sensors are provided within the thermal chamber (1).

9. A heat exchanger according to any one of the preceding claims, wherein the rods (13) are arranged in an helix extending along the axis (14) of the tubular member (11).

10. A heat exchanger according to any one of the preceding claims, wherein additional chilling devices are incorporated into the elements (4) to improve heat exchange.

11. A heat exchanger according to any one of the preceding claims 10, wherein the ratio of the internal diameter of the tubular member (11) to its length is within the range 0.05 to 0.2.

12. A heat exchanger according to claim 11, wherein the ratio is within the range 0.14 to 0.16.

## Patentansprüche

1. Ein Elektronik-Gehäuse umfassend einen Kasten, eine abgedichtete Wärmekammer (1) innerhalb des Kastens, in dem elektronische Komponenten untergebracht sind, einen Wärmetauscher (4), der in dem Kasten außerhalb der Kammer angebracht ist, einen ersten Leitungskanal (2), der von der Wärmekammer zu dem Wärmetauscher führt, und einen zweiten Leitungskanal (6), der von dem Wärmetauscher zurück zu der Wärmekammer führt, und einen Lüfter (7,8), um Luft von der Kammer durch den ersten Leitungskanal zum dem Wärmetauscher und durch den zweiten Leitungskanal zurück zu der Wärmekammer zu drücken, dadurch gekennzeichnet, daß der Wärmetauscher ein Element (4) ist, das ein wärmeleitendes röhrenförmiges Teil (11), das eine Mehrzahl wärmeleitender, sich radial von seiner äußeren Oberfläche nach außen erstreckender Rippen (12) und eine Mehrzahl wärmeleitender Stäbe (13), die sich radial von der inneren Oberfläche des röhrenförmigen Elementes nach innen erstrecken und im Umfang und axial versetzt angeordnet sind, umfaßt, wobei der erste (2) und der zweite (6) Leitungskanal mit dem röhrenförmigen Element (11) verbunden sind, so daß die Luft von der Wärmekammer (1) von dem ersten Leitungskanal durch das röhrenförmige Element hindurch- und in den zweiten Leitungskanal hineingeblasen wird, um zu der Wärmekammer zurückgeführt zu werden.

2. Ein Gehäuse nach Anspruch 1, wobei der Wärmetauscher eine Anzahl parallel verbundener Wärmeaustauschelemente (4) umfaßt.

3. Ein Gehäuse nach Anspruch 2, wobei der Lüfter ein Axiallüfter (7,8) ist und die Wärmeaustauschelemente (4) umfangseitig beabstandet um die und radial von der Achse (15) des Lüfters beabstandet vorgesehen sind.

4. Ein Gehäuse nach einem der vorhergehenden Ansprüche, wobei der Lüfter (7,8) außerhalb der Wärmekammer (1) angebracht ist, so daß sich keine der Komponenten innerhalb der Kammer befindet.

5. Ein Gehäuse nach einem der vorhergehenden Ansprüche, wobei ein weiterer Lüfter (10) vorgesehen ist, um Luft über die äußere Oberfläche des Wärmetauschers (4)zu blasen.

6. Ein Gehäuse nach einem der vorhergehenden Ansprüche, wobei eine zusätzliche Kühleinheit (9) vorgesehen ist, um dem zweiten Leitungskanal (6) Wärme zu entziehen.

7. Ein Gehäuse nach einem der vorhergehenden Ansprüche, wobei ein Wärmesensor bei der Wärmekammer (1) vorgesehen ist und die Geschwindigkeit des Lüfters verändert wird, um die Temperatur innerhalb der Wärmekammer auf einem gewünschten Niveau aufrechtzuerhalten.

8. Ein Gehäuse nach einem der vorhergehenden Ansprüche, wobei eine Mehrzahl Sensoren innerhalb der Wärmekammer (1) vorgesehen sind.

9. Ein Wärmetauscher nach einem der vorhergehenden Ansprüche, wobei die Stäbe (13) als Helix angeordnet sind und sich entlang einer Achse (14) des röhrenförmiges Elements (11) erstrecken.

10. Ein Wärmetauscher nach einem der vorhergehenden Ansprüche, wobei zusätzliche Kühleinrichtungen in die Elemente (4) eingebaut sind, um den Wärmeaustausch zu verbessern.

11. Ein Wärmetauscher nach einem der vorhergehenden Ansprüche, wobei das Verhältnis des inneren Durchmessers des röhrenförmigen Elementes (11) zu seiner Länge innerhalb eines Bereiches von 0,05 bis 0,2 liegt.

12. Ein Wärmetauscher nach Anspruch 11, wobei das Verhältnis innerhalb eines Bereiches von 0,14 bis 0,16 liegt.

## Revendications

1. Enceinte électronique qui comprend un carter, une chambre thermique étanche (1) placée dans le carter et logeant des composants électroniques, un échangeur de chaleur (4) monté dans le carter à l'extérieur de la chambre, un premier conduit (2) partant de la chambre thermique vers l'échangeur de chaleur et un second conduit (6) partant de l'échangeur de chaleur et revenant vers la chambre thermique, et un ventilateur (7, 8) destiné à faire circuler l'air de manière forcée de la chambre vers l'échangeur de chaleur par le premier conduit avec retour à la chambre thermique par le second conduit, caractérisée en ce que l'échangeur de chaleur est un élément (4) qui comprend un organe tubulaire conducteur de la chaleur (11) ayant plusieurs ailettes conductrices de la chaleur (12) qui s'étendent radialement vers l'extérieur de sa surface externe, et plusieurs tiges conductrices de la chaleur (13) qui s'étendent radialement vers l'intérieur depuis la surface interne de l'organe tubulaire et qui sont décalées circonférentiellement et axialement, dans lequel le premier conduit (2) et le second conduit (6) sont raccordés à l'organe tubulaire (11) afin que l'air provenant de la chambre thermique (1) soit soufflé du premier conduit dans l'organe tubulaire et dans le second conduit pour revenir vers la chambre thermique.

2. Enceinte selon la revendication 1, dans laquelle l'échangeur de chaleur comprend un certain nombre d'éléments d'échange de chaleur (4) connectés en parallèle.

3. Enceinte selon la revendication 2, dans laquelle le ventilateur est un ventilateur axial (7, 8) et les éléments d'échange de chaleur (4) sont espacés circonférentiellement autour de l'axe (15) du ventilateur et sont distants radialement de cet axe.

4. Enceinte selon l'une quelconque des revendications précédentes, dans laquelle le ventilateur (7, 8) est monté à l'extérieur de la chambre thermique (1) afin qu'aucun des éléments ne se trouve à l'intérieur de la chambre.

5. Enceinte selon l'une quelconque des revendications précédentes, dans laquelle un ventilateur supplémentaire (10) est destiné à souffler l'air sur la surface externe de l'échangeur de chaleur (4).

6. Enceinte selon l'une quelconque des revendications précédentes, dans laquelle une unité supplémentaire de refroidissement (9) est disposée afin qu'elle extraie la chaleur du second conduit (6).

7. Enceinte selon l'une quelconque des revendications précédentes, dans laquelle un capteur thermique est placé dans la chambre thermique (1), et la vitesse du ventilateur varie afin que la température dans la chambre thermique soit maintenue à un niveau voulu.

8. Enceinte selon la revendication 7, dans laquelle plusieurs capteurs sont placés dans la chambre thermique (1).

9. Echangeur de chaleur selon l'une quelconque des revendications précédentes, dans lequel les tiges (13) sont disposées en hélice le long de l'axe (14) de l'organe tubulaire (11).

10. Echangeur de chaleur selon l'une quelconque des revendications précédentes, dans lequel des dispositifs supplémentaires de refroidissement sont incorporés aux éléments (4) afin qu'ils accroissent l'échange de chaleur.

11. Echangeur de chaleur selon l'une quelconque des revendications précédentes 10, dans lequel le rapport du diamètre interne de l'organe tubulaire (11) à sa longueur est compris entre 0,05 et 0,2.

12. Echangeur de chaleur selon la revendication 11, dans lequel le rapport est compris entre 0,14 et 0,16.
